# EUROPÄISCHE PATENTSCHRIFT

(11) **EP 1 051 666 B1**
(45) Veröffentlichungstag und Bekanntmachung des Hinweises auf die Patenterteilung: **09.04.2003**
(21) Anmeldenummer: 98966536.9
(22) Anmeldetag: 11.12.1998
(51) Int. Cl.: G03F 7/32

(54) **LÖSUNG VON TETRAMETHYLAMMONIUMHYDROXID IN WASSER, VERFAHREN ZUR HERSTELLUNG DER LÖSUNG UND DEREN VERWENDUNG**
SOLUTION OF TETRAMETHYL AMMONIUM HYDROXIDE IN WATER, PROCESS FOR PREPARING THE SOLUTION AND USE THEREOF
SOLUTION D'HYDROXYDE DE TETRAMETHYLAMMONIUM DANS L'EAU, PROCEDE DE PREPARATION DE LA SOLUTION ET UTILISATION CORRESPONDANTE

(30) Priorität: 11.12.1997 DE 19755131
(43) Veröffentlichungstag der Anmeldung: 15.11.2000
(73) Patentinhaber: Infineon Technologies AG, 81669 München (DE)
(72) Erfinder: GEYER, Stefan, D-01277 Dresden (DE); HORN, Michael, D-01129 Dresden (DE)
(74) Vertreter: Banzer, Hans-Jörg, Dipl.-Ing.
(86) Internationale Anmeldenummer: DE9803649
(87) Internationale Veröffentlichungsnummer: WO99030210

(56) Entgegenhaltungen:
- EP-A- 0 474 010
- US-A- 4 847 182

## Beschreibung

Die Erfindung betrifft eine Lösung nach dem Oberbegriff des Anspruchs 1, ferner ein Verfahren zur Herstellung einer Lösung nach dem Oberbegriff des Anspruchs 5 und die Verwendung der Lösung nach Anspruch 4.

Bei der Fabrikation von Wafern wird eine auf den Wafer aufgebrachte und belichtete Photoresistmaske mittels einer Entwicklerflüssigkeit entwickelt. Ein bekannter Entwickler basiert auf einer 2,5% Lösung von Tetramethylammoniumhydroxid (TMAH) in Wasser, wobei der Lösung in geringer Menge ein Tensid beigesetzt ist. Das Tensid hat die Eigenschaft, die Grenzflächenspannung der Entwicklerlösung auf einen geeigneten, definierten Wert herabzusetzen.

Die EP 0 474 010 A1 beschreibt eine Entwicklerzusammensetzung für strahlungsempfindliche, positiv und negativ arbeitende sowie umkehrbare reprographische Schichten, die als wesentlichen Bestandteil neben der strahlungsempfindlichen Verbindung oder Kombination von Verbindungen ein in Wasser unlösliches, in wässrig-alkalisahen Lösungen aber lösliches Bindemittel enthalten, dadurch gekennzeichnet, dass der Entwickler als wesentliche Bestandteile
a) O-Carboxymethyl- oder O,O'-Bis-carboxymethylethylenglykol oder ein entsprechend substituiertes Polyethylenglykol aus 2 bis etwa 500 Ethylenglykol-Einheiten,
b) mindestens eine in wässriger Lösung alkalisch reagierende Verbindung aus der Gruppe der Alkali- und Ammoniumhydroxide, -silikate, -phosphate und -borate und
c) Wasser
enthält. Der Entwickler kann ggf. ein Tensid und/oder eine hydrotrope Substanz enthalten.

Die Menge von in einer Waferfabrik benötigter Entwicklerlösung ist beträchtlich: Für die Entwicklung einer Photoresistmaske auf einem einzigen Wafer werden etwa 50 ml Entwicklerlösung benötigt. Gegenwärtig umfaßt die Herstellung eines fertigen Wafers ungefähr 20 Lithographieschritte, was bedeutet, daß auch 20 Entwicklungsschritte ausgeführt werden müssen. Eine Waferfabrik mit einer Produktion von 10.000 Wafern pro Woche benötigt daher in der Woche etwa 10.000 Liter Entwicklerflüssigkeit. Die Kosten für den Antransport der Entwicklerflüssigkeit sind somit beträchtlich.

Es wurde bereits vorgeschlagen, eine TMAH-Lösung erhöhter Konzentration (beispielsweise 25%) anzuliefern und erst in der Fabrik auf die gewünschte Endkonzentration zu verdünnen. Das hierfür erforderliche deionisierte und hochreine Wasser ist in jeder Waferfabrik vorhanden. Durch diese Maßnahme ließe sich eine Reduzierung der Transportkosten erreichen.

Dabei tritt in der Praxis jedoch das Problem auf, daß das Tensid in einer derartigen konzentrierten Entwicklerlösung bei Normaltemperatur nicht lösbar ist. Das Tensid fällt in der konzentrierten Lösung aus, d.h. assoziiert zu unlöslichen Aggregaten, die sich an Behälterwandungen absetzen können. Aus diesem Grund ist es nicht möglich, das Tensid in einer konzentrierten TMAH-Lösung zu transportieren.

Prinzipiell würde die Möglichkeit bestehen, die Entwicklerlösung in konzentrierter Form ohne Tensid anzuliefern und das Tensid erst nach der Verdünnung der Entwicklerlösung auf ihre gebrauchsfertige Konzentration (etwa 2,5%) zuzusetzen. Bei dieser Vorgehensweise müßte das Tensid jedoch separat in vorverdünnter Form angeliefert werden und es wäre neben der Verdünnung mit Wasser ein weiterer, in bezug auf die Reinheitserfordernisse riskanter Zumischungsschritt erforderlich. Der wesentliche Nachteil besteht jedoch darin, daß es in der Waferfabrik in der Regel nicht möglich ist, die Menge an zugemischtem Tensid ausreichend exakt zu überwachen und zu steuern. Diese Nachteile sind so gravierend, daß diese Vorgehensweise in der Praxis nicht durchgeführt wird.

Der Erfindung liegt die Aufgabe zugrunde, eine Entwicklerlösung zu schaffen, die die mit dem Entwicklungsschritt in Zusammenhang stehenden Kosten bei der Herstellung von Wafern reduziert. Ferner besteht eine Aufgabe der vorliegenden Erfindung darin, ein Verfahren zur Herstellung einer derartigen Lösung anzugeben.

Zur Lösung der ersten Aufgabe sind die kennzeichnenden Merkmale des Anspruchs 1 vorgesehen.

Die erfindungsgemäße Lösung hat den Vorteil, dass sie in einer konzentrierten, insbesondere für Transportzwecke geeigneten Form vorliegt und in eine gebrauchsfertige, niederkonzentrierte Form überführt werden kann.

In der konzentrierten Form - beispielsweise bei einer TMAH-Konzentration von 5%-40% und insbesondere 25% - bewirkt die hydrotrope Komponente, daß die tensidische Komponente auch bei dieser erhöhten TMAH-Konzentrationen löslich ist. Die erfindungsgemäße TMAH-Lösung ist daher in ihrer konzentrierten Form transportierbar, wodurch sich die Menge an zu transportierender Lösung und damit die Transportkosten entsprechend verringern.

Die gebrauchsfertige Entwicklerlösung, die eine Konzentration von etwa 2,5% TMAH aufweist, kann durch einfaches Verdünnen der konzentrierten TMAH-LÖsung mit deionisiertem, hochreinen Wasser gewonnen werden. Dabei hat sich gezeigt, daß die hydrotrope Komponente das Entwicklungsverhalten der Lösung nicht beeinträchtigt.

Die hydrotrope Komponente besteht aus einem oder mehreren der Stoffe Cumolsulfonsäure, Tetramethylammoniumcumolsulfonat, Tetramethylammoniumxylolsulfonat, Tetramethylammoniumtoluolsulfonat, Tetramethylammoniumphenolsulfonat und Tetramethylammoniumbenzolsulfonat.

Die zweite Aufgabe der vorliegenden Erfindung wird gemäß dem kennzeichnenden Merkmal des Anspruchs 5 gelöst.

Zur Herstellung einer für den Transport vorgesehenen, konzentrierten erfindungsgemäßen Lösung kennzeichnet sich das erfindungsgemäße Verfahren dadurch, daß in Schritt b) die tensidische Komponente in einer Konzentration oberhalb des Trübungspunktes zugegeben wird und daß in Schritt c) die hydrotrope Komponente in einer Menge zugegeben wird, die ausreicht, um die Löslichkeit der in Schritt b) zugegebenen tensidischen Komponente zu bewirken. Die Reihenfolge der Zugabe des Tensids und des Hydrotrops ist dabei beliebig und die hydrotrope Komponente ist wie vorstehend definiert.

Weitere vorteilhafte Ausgestaltungen der Erfindung sind in den Unteransprüchen angegeben.

- Die Erfindung wird im folgenden in beispielhafter Weise anhand der Beschreibung von Ausführungsbeispielen erläutert:

Nach einem ersten Ausführungsbeispiel wird zu 100 g einer 25% TMAH Lösung 1 g von statistischem n-Dodecanolpentaoxethylat CH₃-(CH₂-)₁₀CH₂-O-(CH₂-CH₂-O-)₅H hinzugegeben, welches als grenzflächenaktive Substanz (Tensid) wirkt. Das Tensid fällt aus und es bildet sich unter Rühren eine trübe Lösung. Nachfolgend wird 1,2 g Cumolsulfonsäure als Lösungsvermittler (Hydrotrop) hinzugegeben. Unter Rühren wird die Lösung bei Raumtemperatur klar. Der Trübungspunkt der Lösung, der auch als Krafft-Punkt bezeichnet wird, ist temperaturabhängig und liegt bei 33°C. Dies bedeutet, daß die Lösung in ihrer konzentrierten Form bis zu einer Temperatur von 33°C stabil ist.

Wenn anstelle von 1,2 g Cumolsulfonsäure 1,7 g Cumolsulfonsäure hinzugegeben wird, erhöht sich der Trübungspunkt auf 55°C.

Durch 10-fache Verdünnung der Lösung mit Wasserwird eine gebrauchsfertige Entwicklerlösung aufgebaut.

Nach einem zweiten Ausführungsbeispiel wird zu 100 g einer 25% TMAH Lösung 1 g von statistischem Nonylphenoloctadecyloxethylat CH₃-(CH₂-)₈C₆H₄-O-(CH₂-CH₂-O-)₁₈H hinzugegeben, welches als grenzflächenaktive Substanz (Tensid) wirkt. Aufgrund der Ausfällung des Tensids bildet sich unter Rühren eine trübe Lösung. Nachfolgend wird 1,25 g Cumolsulfonsäure als Lösungsvermittler (Hydrotrop) hinzugegeben. Unter Rühren wird die Lösung klar. Der Trübungspunkt der Lösung liegt bei 35°C.

Wenn anstelle von 1,25 g Cumolsulfonsäure 1,70 g Tetramethylammoniumcumolsulfonat (CH₃)₄-N+ -SO₃-C₆H₄-CH-(CH₃)₂ als in Wasser gelöstes Konzentrat hinzugegeben wird, wird ein Trübungspunkt von ebenfalls 35°C erreicht.

Durch 10-fache Verdünnung der Lösung mit Wasser wird wiederum eine gebrauchsfertige Entwicklerlösung erhalten. Das Verhalten dieser Lösung beim Entwicklungsvorgang wird durch das zugesetzte Hydrotrop nicht beeinträchtigt. Bei Tetramethylammoniumcumolsulfonat als Hydrotrop läßt sich dies darauf zurückführen, daß die an dem aromatischen Ring des Tetramethylammoniumcumolsulfonats vorhandene Alkyl-Gruppe aufgrund ihrer Kürze in einer 2,5% verdünnten TMAH-Lösung keinerlei Oberflächenaktivität zeigen kann.

Allen vorstehend beschriebenen Ausführungsbeispielen ist gemeinsam, daß durch Zugabe eines Hydrotrops in ausreichender Menge eine Phasentrennung in einer konzentrierten TMAH-Lösung mit tensidischer Komponente sicher verhindert werden kann, wodurch erreicht wird, daß das Tensid auch in der konzentrierten TMAH-Lösungen (beispielsweise 25%) in einer stabilen und klaren Lösung gehalten werden kann. Dies ermöglicht es, die gebrauchsfertige Entwicklerlösung im Rahmen einer Vor-Ort-Verdünnung der konzentrierten TMAH-Lösung in der Waferfabrik herzustellen, wodurch eine wesentliche Reduzierung der Transportkosten erzielt wird.

## Patentansprüche

1. Lösung von Tetramethylammoniumhydroxid in Wasser, die eine tensidische Komponente und
eine hydrotrope Komponente enthält,
**dadurch gekennzeichnet,**
**dass** die Lösung eine 5% bis 40%-ige Lösung von Tetramethylammoniumhydroxid in Wasser ist, und dass sie die tensidische Komponente in einer Konzentration oberhalb des Trübungspunktes und die hydrotrope Komponente in einer Menge, die ausreicht, um die Löslichkeit der tensidischen Komponente zu bewirken, enthält, wobei die hydrotrope Komponenten einen oder mehrere der Stoffe Cumolsulfonsäure, Tetramethylammoniumcumolsulfonat, Tetramethylammoniumxylolsulfonat, Tetramethylammoniumtoluolsulfonat, Tetramethylammoniumphenolsulfonat und Tetramethylammoniumbenzolsulfonat enthält.

2. Lösung nach Anspruch 1.
**dadurch gekennzeichnet,**
**dass** sie eine etwa 25%-ige Lösung von Tetramethylammoniumhydroxid in Wasser ist.

3. Lösung nach einem der vorhergehenden Ansprüche,
**dadurch gekennzeichnet,**
**dass** die tensidische Komponente einen oder mehrere der Stoffe Dodecanolpentaoxethylat und Nonylphenoloctadecyloxethylat enthält.

4. Verwendung der Lösung nach einem der vorhergehenden Ansprüche in verdünnter Endkonzentration zum Entwickeln von Photoresistmasken.

5. Verfahren zur Herstellung einer Lösung für die Entwicklung eines belichteten Photoresists, dass die folgenden Schritte umfasst:
a) Herstellung einer Lösung von Tetramethylammoniumhydroxid in Wasser,
b) Zugabe einer tensidischen Komponente, und
c) Zugabe einer hydrotropen Komponente,
**dadurch gekennzeichnet,**
**dass** in Schritt b) die tensidische Komponente in einer Konzentration oberhalb des Trübungspunktes zugegeben wird und dass in Schritt c) die hydrotrope Komponente in einer Menge zugegeben wird, die ausreicht, um die Löslichkeit der in Schritt b) zugegebenen tensidischen Komponente zu bewirken, wobei die hydrotrope Komponente einen oder mehrere der Stoffe Cumolsulfonsäure, Tetramethylammoniumcumolsulfonat, Tetramethylammoniumxylolsulfonat, Tetramethylammoniumtoluolsulfonat, Tetramethylammoniumphenolsulfonat und Tetramethylammoniumbenzolsulfonat enthält und wobei insbesondere die Reihenfolge der Zugabe der tensidischen und der hydrotropen Komponente beliebig ist.

6. Verfahren nach Anspruch 5,
**dadurch gekennzeichnet,**
**dass** in Schritt a) eine 5% bis 40%-ige Lösung, insbesondere etwa 25%-ige Lösung von Tetramethylammoniumhydroxid in Wasser hergestellt wird.

7. Verfahren nach einem der Ansprüche 5 oder 6,
**gekennzeichnet durch** den weiteren Schritt:
d) Verdünnen der Lösung mit deionisiertem Wasser zum Erreichen einer Konzentration von Tetramethylammoniumhydroxid, die die Lösung als Entwicklerlösung in einem Photoresist-Entwicklungsschritt geeignet macht.

8. Verfahren nach Anspruch 7,
**dadurch gekennzeichnet,**
**dass** die Lösung auf eine 2% bis 5%-ige, insbesondere etwa eine 2,5%-ige Lösung von Tetramethylammoniumhydroxid in Wasser verdünnt wird.

9. Verfahren nach einem der Ansprüche 5 bis 8,
**dadurch gekennzeichnet,**
**dass** die tensidische Komponente einen oder mehrere der Stoffe Dodecanolpentaoxethylat und Nonylphenoloctadecyloxethylat enthält.

## Claims

1. A solution of tetramethylammonium hydroxide in water containing a surfactant component and a hydrotropic component, **characterized in that** said solution is a 5-40% strength solution of tetramethylammonium hydroxide in water and **in that** it contains the surfactant component in a concentration above the cloud point and the hydrotropic component in an amount sufficient to solubilize the surfactant component, wherein the hydrotropic component comprises one or more of cumenesulfonic acid, tetramethylammonium cumenesulfonate, tetramethylammonium xylenesulfonate, tetramethylammonium toluenesulfonate, tetramethylammonium phenolsulfonate and tetramethylammonium benzenesulfonate.

2. Solution according to claim 1, **characterized in that** it is an approximately 25% strength solution of tetramethylammonium hydroxide in water.

3. Solution according to any one of the preceding claims, **characterized in that** the surfactant component contains one or more of dodecanol pentaethoxylate and nonylphenol octadecaethoxylate.

4. Use of the solution according to any one of the preceding claims in a diluted end concentration for developing photoresist masks.

5. A process for preparing a solution for developing an exposed photoresist, which comprises the following steps:
a) preparation of a solution of tetramethylammonium hydroxide in water,
b) addition of a surfactant component, and
c) addition of a hydrotropic component, **characterized in that** step b) comprises adding the surfactant component in a concentration above the cloud point and step c) comprises adding the hydrotropic component in an amount sufficient to solubilize the surfactant component added in step b), wherein the hydrotropic component contains one or more of cumenesulfonic acid, tetramethylammonium cumenesulfonate, tetramethylammonium xylenesulfonate, tetramethylammonium toluenesulfonate, tetramethylammonium phenolsulfonate and tetramethylammonium benzenesulfonate and **in that** in particular the sequence of the addition of the surfactant and of the hydrotropic component is interchangeable.

6. Process according to claim 5, **characterized in that** step a) comprises the preparation of a 5-40% strength, in particular an approximately 25% strength solution of tetramethylammonium hydroxide in water.

7. Process according to any one of claims 5 or 6, **characterized by** the further step:
d) dilution of said solution with deionized water to achieve a tetramethylammonium hydroxide concentration which renders the solution suitable as developer solution in a photoresist development step.

8. Process according to claim 7, **characterized in that** said solution is diluted to a 2-5% strength, in particular an approximately 2.5% strength solution of tetrametyhlammonium hydroxide in water.

9. Process according to any one of claims 5 to 8, **characterized in that** the surfactant component contains one or more of dodecanol pentaethoxylate and nonylphenol octadecaethoxylate.

## Revendications

1. Solution d'hydroxyde de tétraméthylammonium dans l'eau contenant un composé tensioactif et un composé hydrotrope, **caractérisée en ce que** la solution est une solution à de 5 à 40% d'hydroxyde de tétraméthylammonium dans l'eau et qu'elle contient le composé tensioactif à une concentration supérieure au point de trouble et le composé hydrotrope en une quantité suffisante pour provoquer la solubilité du composé tensioactif, le composé hydrotrope contenant une ou plusieurs des substances suivantes : acide cumènesulfonique, cumènesulfonate de tétraméthylammonium, xylènesulfonate de tétraméthylammonium, toluènesulfonate de tétraméthylammonium, phénolsulfonate de tétraméthylammonium et benzènesulfonate de tétraméthylammonium.

2. Solution selon la revendication 1, **caractérisée en ce qu'**il s'agit d'une solution à 25% d'hydroxyde de tétraméthylammonium dans l'eau.

3. Solution selon l'une quelconque des revendications précédentes, **caractérisée en ce que** le composé tensioactif contient une ou plusieurs des substances dodécanolpentaoxéthylate et nonylphénoloctadécyloxéthylate.

4. Utilisation de la solution selon l'une quelconque des revendications précédentes en concentration finale diluée pour le développement de masques de résine photosensible.

5. Procédé de fabrication d'une solution pour le développement d'une résine photosensible exposée comprenant les étapes suivantes :
a) fabrication d'une solution d'hydroxyde de tétraméthylammonium dans l'eau,
b) ajout d'un composé tensioactif, et
c) ajout d'un composé hydrotrope,
**caractérisé en ce que**, à l'étape b), le composé tensioactif est ajouté à une concentration supérieure au point de trouble et que, à l'étape c), le composé hydrotrope est ajouté dans une quantité suffisante pour provoquer la solubilité du composé tensioactif ajouté à l'étape b), le composé hydrotrope contenant une ou plusieurs des substances acide cumènesulfonique, cumènesulfonate de tétraméthylammonium, xylènesulfonate de tétraméthylammonium, toluènesulfonate de tétraméthylammonium, phénolsulfonate de tétraméthylammonium et benzènesulfonate de tétraméthylammonium, et, en particulier, l'ordre des ajouts des composés tensioactif et hydrotrope étant quelconque.

6. Procédé selon la revendication 5, **caractérisé en ce que**, à l'étape a), une solution à 5 à 40%, en particulier une solution à 25% d'hydroxyde de tétraméthylammonium dans l'eau est fabriquée.

7. Procédé selon les revendications 5 ou 6, **caractérisé par** l'étape supplémentaire suivante :
d) dilution de la solution avec de l'eau désionisée pour atteindre une concentration d'hydroxyde de tétraméthylammonium rendant la solution apte à servir de solution de révélateur pendant une étape de développement de résine photosensible.

8. Procédé selon la revendication 7, **caractérisé en ce que** la solution est diluée dans l'eau à une concentration de 2 à 5%, en particulier à environ 2,5%, d'hydroxyde de tétraméthylammonium.

9. Procédé selon l'une quelconque des revendications 5 à 8, **caractérisé en ce que** le composé tensioactif contient une ou plusieurs des substances dodécanolpentaoxéthylate et nonylphénoloctadécyloxéthylate.
